# EUROPEAN PATENT APPLICATION

(11) **EP 4 489 068 A1**
(43) Date of publication of application: **08.01.2025**
(21) Application number: 24185047.8
(22) Date of filing: 27.06.2024
(51) Int. Cl.: H01L 23/367, H01L 23/40

(54) **COOLING SYSTEM BLOCK ASSEMBLY**

(30) Priority: 07.07.2023 TW 112125373
(71) Applicant: Purple Cloud Development Pte. Ltd., Singapore 128424 (SG)
(72) Inventor: TSENG, Hsiang-Chieh, Taiwan (TW); CHEN, Yung-Hao, Taiwan (TW)
(74) Representative: Grünecker Patent- und Rechtsanwälte PartG mbB

(57) **Abstract**

A cooling system block assembly may include a cooling system block and a circuit board assembly. The cooling system block includes a plurality of attachment members and one or more positioning members. The circuit board assembly is fixed to the cooling system block via the plurality of attachment members. The circuit board assembly includes a socket and a plate. The socket includes one or more positioning hubs or one or more positioning pins, and the plate includes a plurality of attachment hubs. The one or more positioning members is disposed within the one or more positioning hubs or disposed around the one or more positioning pins and the plurality of attachment members is fixed within the plurality of attachment hubs. When the one or more positioning members is disposed within the one or more positioning hubs or is disposed encompassing the one or more positioning pins and the plurality of attachment members is not fixed within the plurality of attachment hubs, the plurality of attachment members is vertically aligned with the plurality of attachment hubs.

## Description

### TECHNICAL FIELD

The present disclosure relates to heat-transfer components and assemblies, and more particularly, but not limited to, cooling system block assemblies.

### BACKGROUND OF THE INVENTION

With increasing processing speed and performance of electronic devices, the amount of heat generated during operation of an electronic device has increased. The heat generation increases the temperature of the electronic device and, if the heat cannot be dissipated effectively, the reliability and performance of the electronic device is reduced. To prevent overheating of an electronic device, cooling systems such as air-cooling systems and liquid cooling systems are used to efficiently dissipate the heat generated by the electronic device and, thereby ensure the standard operation of the electronic device.

In the case of air-cooling systems for packaged integrated circuits, heat is dissipated from an upper surface of a packaged integrated circuit via upper surface adherence of a heatsink or cooling system block to the packaged integrated circuit. The heatsink or cooling system block is commonly mounted to the packaged integrated circuits via attachment members such as screws and push pins. Thermal pads (also called thermally conductive pad or thermal interface pad) and thermal paste (also called thermal compound, thermal grease, thermal interface material (TIM), heat sink compound, heat sink paste or CPU grease) may be used to enhance adherence and aid in heat conduction. The thermal pads and thermal paste fill in air gaps caused by imperfections of the adhered surfaces allowing for effective heat transfer.

Often, when mounting, positioning members, such as the screws and the push pins and other separate positioning members, are fixed to the heatsink or cooling system block and/or a circuit board for vertical alignment of the attachment members before fixing. Thus, priorto fixing, the heatsink or cooling system block is prevented from moving horizontally via the positioning members. However, following operation of the electronic devices, an adhesive force between the heatsink or cooling system block and packaged integrated circuit increases. Thus, when the heatsink or cooling system block is unmounted from the packaged integrated circuits, difficulty in separating the adhered surfaces from each other increases. Separating the heatsink or cooling system block from the packaged integrated circuit is further exacerbated as the heatsink or cooling system block is prevented from moving horizontally. Due to the increased adhesive force and vertical pulling of the heatsink or cooling system block, the packaged integrated circuit may be damaged or become inoperable. Separately unfixing the positioning members from the heatsink or cooling system block and/or a circuit board makes unmounting inconvenient, time-consuming, and inefficient, and lost parts of and damage to the positioning members more likely.

### SUMMARY OF THE INVENTION

The present disclosure provides a cooling system block assembly that is configured to enable vertical alignment of attachment members for mounting to a packaged integrated circuit and horizontal movement for unmounting from the packaged integrated circuit.

In some aspects, the techniques described herein relate to a cooling system block assembly including a cooling system block and a circuit board. The cooling system block includes a plurality of attachment members and one or more positioning members. The plurality of attachment members is rotatably disposable through and vertically movable within the cooling system block and the one or more positioning members is removably fixable through and vertically movable within the cooling system block. The circuit board assembly is fixed to the cooling system block via the plurality of attachment members. The circuit board assembly includes a socket and a plate. The socket includes one or more positioning hubs or one or more positioning pins (or positioning knobs), and the plate includes a plurality of attachment hubs. The one or more positioning members is rotatably disposable within the one or more positioning hubs or rotatably disposable encompassing (surrounding) the one or more positioning pins, and the plurality of attachment members is removably fixable within the plurality of attachment hubs. When the one or more positioning members is disposed within the one or more positioning hubs or is disposed encompassing the one or more positioning pins and the plurality of attachment members is not fixed within the plurality of attachment hubs, the plurality of attachment members is vertically aligned with the plurality of attachment hubs.

In some aspects, the techniques described herein relate to a cooling system block assembly, wherein the cooling system block further includes a longitudinal axis and a lateral axis. When the one or more positioning members is not disposed within the one or more positioning hubs or is not disposed encompassing the one or more positioning pins and the plurality of attachment members is not fixed within the plurality of attachment hubs, the cooling system block is movable in a longitudinal axis direction and in a lateral axis direction.

In some aspects, the techniques described herein relate to a cooling system block assembly, further including a fin stack and a plurality of heat pipes. The plurality of heat pipes includes a fin stack portion, a transportation portion, and a cooling system block portion. The transportation portion is between the fin stack portion and the cooling system block portion. The fin stack portion is coupled to the fin stack and the cooling system block portion is coupled to the cooling system block.

In some aspects, the techniques described herein relate to a cooling system block assembly, wherein the circuit board assembly further includes a circuit board and the socket further includes a plurality of socket through-holes. The circuit board includes a plurality of board through-holes. The circuit board is coupled between the socket and the plate and the plurality of attachment hubs protrudes through the plurality of board through-holes and the plurality of socket through-holes.

In some aspects, the techniques described herein relate to a cooling system block assembly, wherein the packaged integrated circuit is electrically coupled to the circuit board via the socket, and wherein the cooling system block is thermally coupled to an upper surface of the packaged integrated circuit.

In some aspects, the techniques described herein relate to a cooling system block assembly, wherein the cooling system block further includes a plurality of second counterbores, and wherein each plurality of attachment members respectively includes a compression member and a securing ring. Each plurality of second counterbores respectively includes an inner annular ledge. The plurality of attachment members is rotatably disposable through and vertically movable within the cooling system block via the plurality of second counterbores. When the plurality of attachment members is not fixed within the plurality of attachment hubs, the securing ring abuts a first side of the inner annular ledge and the compression member abuts a second side of the inner annular ledge. The second side is opposite the first side.

In some aspects, the techniques described herein relate to a cooling system block assembly, wherein the compression member includes a first compression force and a second compression force. When the plurality of attachment members is not fixed within the plurality of attachment hubs, the compression member includes the first compression force. When the plurality of attachment members is fixed within the plurality of attachment hubs, the securing ring does not abut the first side and the compression member includes the second compression force. The second compression force is greater than the first compression force.

In some aspects, the techniques described herein relate to a cooling system block assembly, wherein the cooling system block further includes one or more first counterbores, and wherein each one or more positioning members includes a head, an external threaded portion, and a positioning knob or a positioning bore. The external threaded portion is between the head and the positioning knob or the positioning bore. Each one or more first counterbores includes an inner threaded portion. The one or more positioning members is removably fixable through and vertically movable within the cooling system block via the one or more first counterbores. The positioning knob is movable into and out of the one or more positioning hubs, or the one or more positioning pins is relatively movable into and out of the positioning bore. Preferably, the one or more positioning members is disposed within the one or more positioning hubs via the external threaded portion threaded within the inner threaded portion and the positioning knob protruding within the one or more positioning hubs.

In some aspects, the techniques described herein relate to a cooling system block assembly, wherein the cooling system block further includes four corners, and wherein the plurality of attachment members includes four plurality of attachment members. The plurality of attachment members is rotatably disposable through and vertically movable within the cooling system block at the four corners of the cooling system block.

In some aspects, the techniques described herein relate to a cooling system block assembly, wherein the one or more positioning members further includes two one or more positioning members. The one or more positioning members is removably fixable through and vertically movable within the cooling system block at two opposing sides of the cooling system block and between two opposing plurality of attachment members.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of cooling system block assemblies incorporating aspects of the presently disclosed principles are illustrated by way of example, and not by way of limitation.
Fig. 1 illustrates a perspective view of a cooling system block assembly, in accordance with various embodiments of the present disclosure.
Fig. 2 illustrates a side, partial cross-sectional view of the cooling system block assembly of Fig. 1, in accordance with various embodiments of the present disclosure.
Fig. 3 illustrates another side, partial cross-sectional view of the cooling system block assembly of Fig. 1, in accordance with various embodiments of the present disclosure.
Fig. 4 illustrates yet another side, partial cross-sectional view of the cooling system block assembly of Fig. 1, in accordance with various embodiments of the present disclosure.
Fig. 5 illustrates further yet another side, partial cross-sectional view of the cooling system block assembly of Fig. 1, in accordance with various embodiments of the present disclosure.
Fig. 6 illustrates a side, partial cross-sectional view of a modified cooling system block assembly, in accordance with various embodiments of the present disclosure.

### DETAILED DESCRIPTION

The following describes various principles related to components and assemblies for electronic devices cooling by way of reference to specific examples of cooling system block assemblies, including specific arrangements and examples of vertical alignment of attachment members and longitudinal axis direction and lateral axis direction movement of the cooling system block embodying innovative concepts. More particularly, but not exclusively, such innovative principles are described in relation to selected examples of attachment members being fixed within attachment hubs and positioning members being disposed within positioning hubs, and well-known functions or constructions are not described in detail for purposes of succinctness and clarity. Nonetheless, one or more of the disclosed principles can be incorporated in various other embodiments of attachment members being fixed within attachment hubs and positioning members being disposed within positioning hubs to achieve any of a variety of desired outcomes, characteristics, and/or performance criteria.

Thus, attachment members being fixed within attachment hubs and positioning members being disposed within positioning hubs having attributes that are different from those specific examples discussed herein can embody one or more of the innovative principles, and can be used in applications not described herein in detail. Accordingly, embodiments of attachment members being fixed within attachment hubs and positioning members being disposed within positioning hubs not described herein in detail also fall within the scope of this disclosure, as will be appreciated by those of ordinary skill in the relevant art following a review of this disclosure.

Example embodiments as disclosed herein are directed to cooling system block assemblies that can be used in cooling systems to dissipate high heat loads. The cooling system block assembly may be configured on a chassis, within a chassis, or as part of an electronics system that includes heat producing electronic components to be cooled. The cooling system block assembly may be thermally coupled to an upper surface of the packaged integrated circuit, absorbing heat from the packaged integrated circuit and transporting the heat away via heat pipes coupled to a fin stack. The heat may be transported to an air plenum or to an outside of a chassis or electronics system via the fin stack, naturally or forced (e.g. computer fan). The integrated circuit may include central processing units (CPUs), graphics processing units (GPUs), neural network processing units (NPUs), tensor processing units (TPUs) etc.

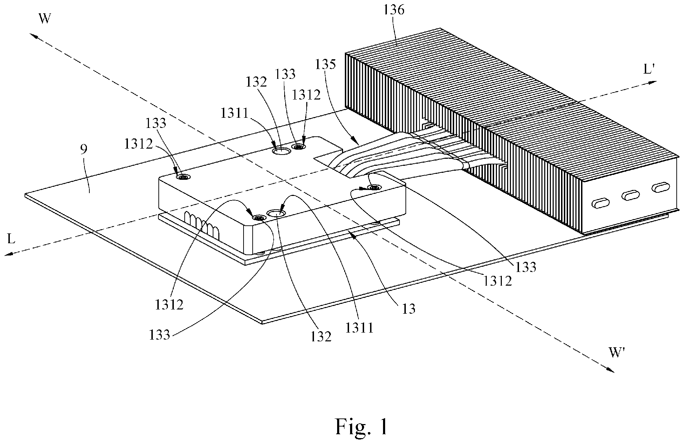

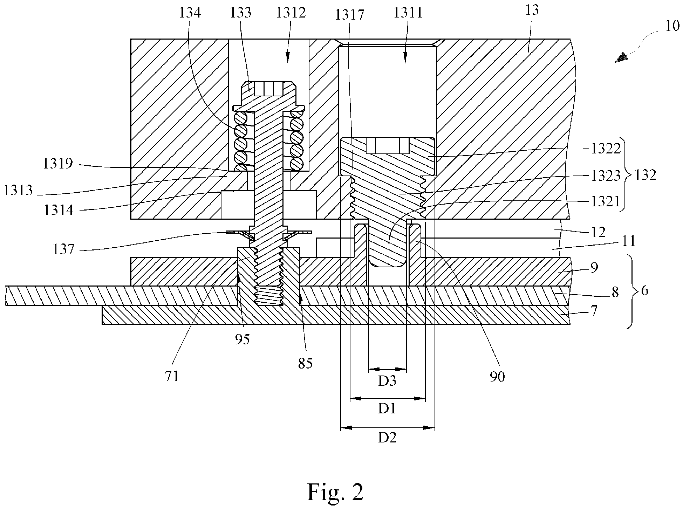

Figs. 1 to 5 illustrate a cooling system block assembly 10, in accordance with various embodiments of the present disclosure. The cooling system block assembly 10 includes a cooling system block 13 and a circuit board 8. The cooling system block 13 includes a plurality of attachment members 133 and one or more positioning members 132. The plurality of attachment members 133 is rotatably disposable through and vertically movable within the cooling system block 13 and the one or more positioning members 132 is removably fixable through and vertically movable within the cooling system block 13. The circuit board assembly 6 is fixed to the cooling system block 13 via the plurality of attachment members 133. The circuit board assembly 6 includes a socket 9 and a plate 7. The socket 9 includes one or more positioning hubs 90 and the plate 7 includes a plurality of attachment hubs 71. The one or more positioning members 132 is rotatably disposable within the one or more positioning hubs 90 and the plurality of attachment members 133 is removably fixable within the plurality of attachment hubs 71. When the one or more positioning members 132 is disposed within the one or more positioning hubs 90 and the plurality of attachment members 133 is not fixed within the plurality of attachment hubs 71, the plurality of attachment members 133 is vertically aligned with the plurality of attachment hubs 71.

In some embodiments, the cooling system block assembly 10 further includes a longitudinal axis L-L' and a lateral axis W-W'. When the one or more positioning members 132 is not disposed within the one or more positioning hubs 90 and the plurality of attachment members 133 is not fixed within the plurality of attachment hubs 71, the cooling system block 13 is movable in a longitudinal axis direction L-L' and in a lateral axis direction L-L'.

In some embodiments, the cooling system block assembly 10 further includes a fin stack 136 and a plurality of heat pipes 135. The plurality of heat pipes 135 includes a fin stack portion, a transportation portion, and a cooling system block portion, and has working fluid (not shown) therein. The transportation portion is between the fin stack portion and the cooling system block portion. The fin stack portion is coupled to the fin stack 136, defining a condenser end portion of the plurality of heat pipes 135 and the cooling system block portion is coupled to the cooling system block 13, defining an evaporator end portion of the plurality of heat pipes 135.

In some embodiments, the circuit board assembly 6 further includes a circuit board 8 and the socket 9 further includes a plurality of socket through-holes 95. The circuit board 8 includes a plurality of board through-holes 85. The circuit board 8 is coupled between the socket 9 and the plate 7 and the plurality of attachment hubs 71 protrudes through the plurality of board through-holes 85 and the plurality of socket through-holes 95.

In some embodiments, the packaged integrated circuit 12 is mounted to a substrate 11 and electrically coupled to the circuit board 8 via the socket 9, and the cooling system block 13 is thermally coupled to an upper surface of the packaged integrated circuit 12. The circuit board 8 may be a motherboard for a personal computer, a processor board, a memory board, a graphics board or the like.

In some embodiments, the cooling system block 13 further includes a plurality of second counterbores 1312. Each plurality of attachment members 133 respectively includes a compression member 134 and a securing ring 137. Each plurality of second counterbores 1312 respectively includes an inner annular ledge 1313. The plurality of attachment members 133 is rotatably disposable through and vertically movable within the cooling system block 13 via the plurality of second counterbores 1312. When the plurality of attachment members 133 is not fixed within the plurality of attachment hubs 71, the securing ring 137 abuts a first side 1314 of the inner annular ledge 1313 and the compression member 134 abuts a second side 1319 of the inner annular ledge 1313. The second side 1319 is opposite the first side 1314. The compression member 134 includes fasteners such as spring-loaded screws, screws, etc. The securing ring 137 is respectively fixed to each plurality of attachment members 133.

In some embodiments, the compression member 134 includes a first compression force and a second compression force. When the plurality of attachment members 133 is not fixed within the plurality of attachment hubs 71, the compression member 134 includes the first compression force. When the plurality of attachment members 133 is fixed within the plurality of attachment hubs 71, the securing ring 137 does not abut the first side 1314 and the compression member 134 includes the second compression force. The second compression force is greater than the first compression force and the second compression force is configured to increase tension per unit of torque, securing each plurality of attachment members 133 to each plurality of attachment hubs 71 when fixed thereto.

In some embodiments, the cooling system block 13 further includes one or more first counterbores 1311. Each one or more positioning members 132 includes a head 1322, an external threaded portion 1323, and a positioning knob 1321. The external threaded portion 1323 is between the head 1322 and the positioning knob 1321. Each one or more first counterbores 1311 includes an inner threaded portion 1317. The one or more positioning members 132 is removably fixable through and vertically movable within the cooling system block 13 via the one or more first counterbores 1311 such that the positioning knob 1321 is movable into and out of the one or more positioning hubs 90. The one or more positioning members 132 is disposed within the one or more positioning hubs 90 via the external threaded portion 1323 threaded within the inner threaded portion 1317 and the positioning knob 1321 protruding within the one or more positioning hubs 90. A diameter D2 of the head 1322 is larger than a diameter D1 of the external threaded portion 1323, and the diameter D1 of the external threaded portion 1323 is larger than a diameter D3 of the positioning knob 1321.

In some embodiments, the cooling system block 13 further includes four corners, and the plurality of attachment members 133 includes four plurality of attachment members 133. The plurality of attachment members 133 is rotatably disposable through and vertically movable within the cooling system block 13 at the four corners of the cooling system block 13.

In some embodiments, the one or more positioning members 132 further includes two one or more positioning members 132. The one or more positioning members 132 is removably fixable through and vertically movable within the cooling system block 13 at two opposing sides of the cooling system block 13 and between two opposing plurality of attachment members 133.

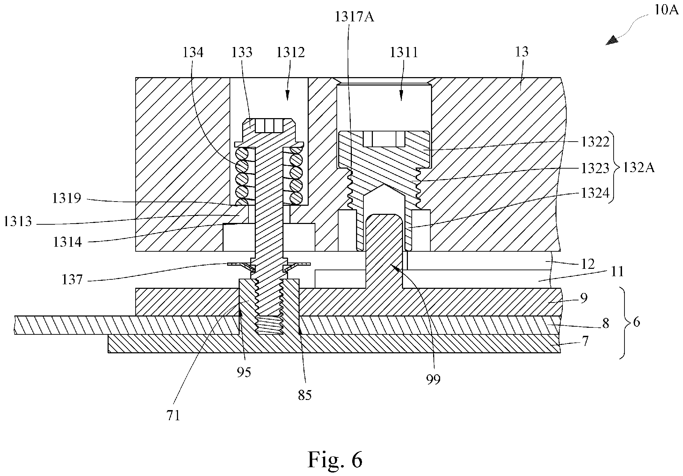

Fig. 6 illustrates a modified cooling system block assembly 10A, in accordance with various embodiments of the present disclosure. The modified cooling system block assembly 10A may be similar in some respects to the cooling system block assembly 10 of Figs. 1 to 5, and therefore may be best understood with reference thereto where like numerals designate like components not described again in detail. The modified cooling system block assembly 10A includes a cooling system block 13 and a circuit board 8. The cooling system block 13 includes a plurality of attachment members 133 and one or more modified positioning members 132A. The plurality of attachment members 133 is rotatably disposable through and vertically movable within the cooling system block 13. The one or more modified positioning members 132A is removably fixable through and vertically movable within the cooling system block 13. The circuit board assembly 6 is fixed to the cooling system block 13 via the plurality of attachment members 133. The circuit board assembly 6 includes a socket 9 and a plate 7. The socket 9 includes one or more positioning pins 99. The plate 7 includes a plurality of attachment hubs 71. The one or more modified positioning members 132A is rotatably disposable and encompass the one or more positioning pins 99. The plurality of attachment members 133 is removably fixable within the plurality of attachment hubs 71. When the one or more modified positioning members 132A is disposed encompassing the one or more positioning pins 99 and the plurality of attachment members 133 is not fixed within the plurality of attachment hubs 71, the plurality of attachment members 133 is vertically aligned with the plurality of attachment hubs 71.

In some embodiments of the modified cooling system block assembly 10A, the cooling system block 13 further includes a longitudinal axis L-L' and a lateral axis W-W'. When the one or more modified positioning members 132A is not disposed encompassing the one or more positioning pins 99 and the plurality of attachment members 133 is not fixed within the plurality of attachment hubs 71, the cooling system block 13 is movable in a longitudinal axis direction L-L' and in a lateral axis direction L-L'.

In some embodiments, the modified cooling system block assembly 10A further includes a fin stack 136 and a plurality of heat pipes 135. The plurality of heat pipes 135 includes a fin stack portion, a transportation portion, and a cooling system block portion. The transportation portion is between the fin stack portion and the cooling system block portion. The fin stack portion is coupled to the fin stack 136 and the cooling system block portion coupled to the cooling system block 13.

In some embodiments of the modified cooling system block assembly 10A, the circuit board assembly 6 further includes a circuit board 8, and wherein the socket 9 further includes a plurality of socket through-holes 95. The circuit board 8 includes a plurality of board through-holes 85. The circuit board 8 is coupled between the socket 9 and the plate 7. The plurality of attachment hubs 71 protrudes through the plurality of board through-holes 85 and the plurality of socket through-holes 95.

In some embodiments of the modified cooling system block assembly 10A, the packaged integrated circuit 12 is electrically coupled to the circuit board 8 via the socket 9, and wherein the cooling system block 13 is thermally coupled to an upper surface of the packaged integrated circuit 12.

In some embodiments of the modified cooling system block assembly 10A, the cooling system block 13 further includes a plurality of second counterbores 1312. Each plurality of attachment members 133 respectively includes a compression member 134 and a securing ring 137. Each plurality of second counterbores 1312 respectively includes an inner annular ledge 1313. The plurality of attachment members 133 is rotatably disposable through and vertically movable within the cooling system block 13 via the plurality of second counterbores 1312. When the plurality of attachment members 133 is not fixed within the plurality of attachment hubs 71, the securing ring 137 abuts a first side 1314 of the inner annular ledge 1313 and the compression member 134 abuts a second side 1319 of the inner annular ledge 1313. The second side 1319 is opposite the first side 1314.

In some embodiments of the modified cooling system block assembly 10A, the compression member 134 includes a first compression force and a second compression force. When the plurality of attachment members 133 is not fixed within the plurality of attachment hubs 71, the compression member 134 includes the first compression force. When the plurality of attachment members 133 is fixed within the plurality of attachment hubs 71, the securing ring 137 does not abut the first side 1314 and the compression member 134 includes the second compression force. The second compression force is greater than the first compression force.

In some embodiments of the modified cooling system block assembly 10A, the cooling system block 13 further includes one or more first counterbores 1311. Each one or more modified positioning members 132A includes a head 1322, an external threaded portion 1323, and a positioning bore 1324. Each one or more first counterbores 1311 includes a modified inner threaded portion 1317A. The external threaded portion 1323 is between the head 1322 and the positioning bore 1324. The one or more modified positioning members 132A is removably fixable through and vertically movable within the cooling system block 13 via the one or more first counterbores 1311 such that the one or more positioning pins 99 is relatively movable into and out of the positioning bore 1324 by way of actual movement of the positioning member 134A. The one or more modified positioning members 132A is disposed encompassing the one or more positioning pins 99 via the external threaded portion 1323 threaded within the modified inner threaded portion 1317A and the one or more positioning pins 99 protruding within the positioning bore 1324.

In some embodiments of the modified cooling system block assembly 10A, the cooling system block 13 further includes four corners, and the plurality of attachment members 133 includes four plurality of attachment members 133. The plurality of attachment members 133 is rotatably disposable through and vertically movable within the cooling system block 13 atthe four corners of the cooling system block 13.

In some embodiments of the modified cooling system block assembly 10A, the one or more modified positioning members 132A further includes two one or more modified positioning members 132A. The one or more modified positioning members 132A is removably fixable through and vertically movable within the cooling system block 13 at two opposing sides of the cooling system block 13 and between two opposing plurality of attachment members 133.

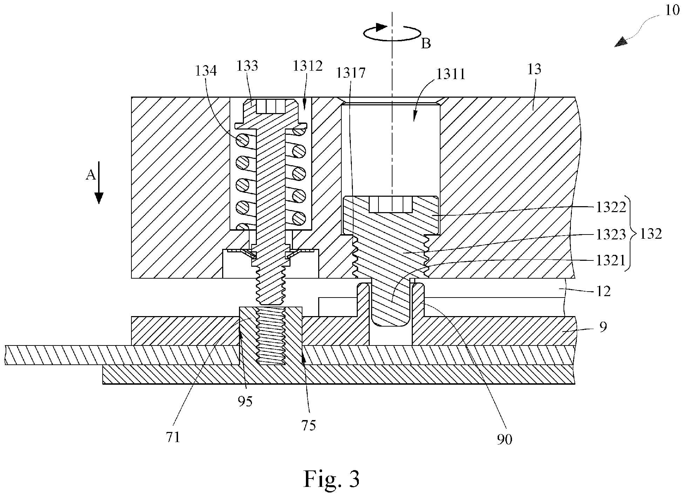

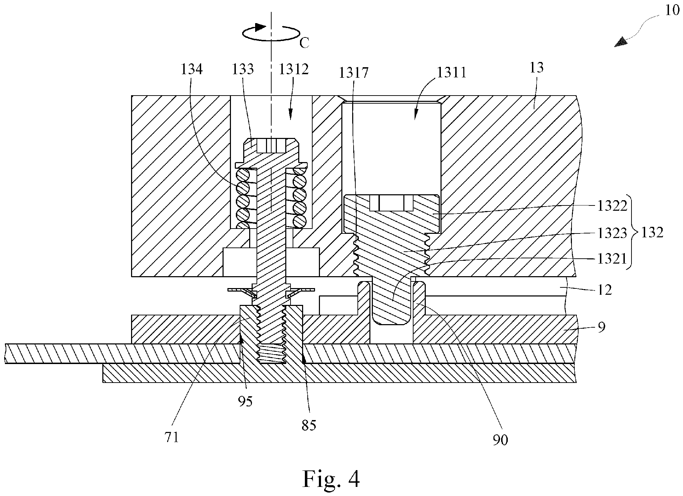

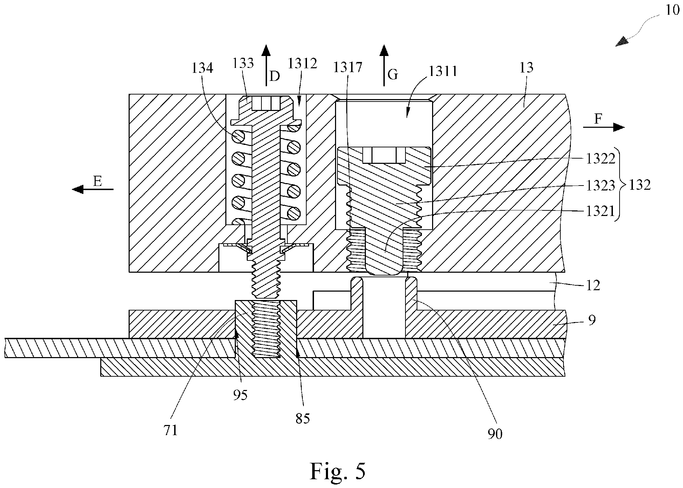

In the embodiments of the present disclosure, the attachment members 133 are vertically aligned for fixing when mounting the cooling system block 13 to the packaged integrated circuit 12. Before the attachment members 133 are fixed within the attachment hubs 71, the positioning members 132 can be fixed within the cooling system block 13 and the positioning knob 1321 can be received within the positioning hub 90, as shown by the B arrow direction and an arrow direction of Fig. 3. Thus, the positioning members 132 vertically align the attachment members 133 with the attachment hubs 71 for accurate, efficient, and uniformly distributed compressive load fixing of the cooling system block 13 to the packaged integrated circuit 12, as shown by the C arrow direction of Fig. 4. Also, in the embodiments of the present disclosure, the cooling system block 13 can be moved horizontally when being separated from the packaged integrated circuit 12. After the attachment members 133 are unfixed from the attachment hubs 71 and the positioning members 132 are unfixed from the cooling system block 13, the positioning knob 1321 is extracted from the positioning hub 90, as shown by the D arrow direction and G arrow direction of Fig. 5. Thus, the cooling system block 13 is movable in a longitudinal axis direction L-L', a lateral axis direction L-L', a vertical axis direction, or any available direction to unmount the cooling system block 13 from the packaged integrated circuit 12, making separation more convenient and efficient, despite increased adhesive force between the cooling system block 13 and the packaged integrated circuit 12 following operation of the packaged integrated circuit 12, as partly shown by the E arrow direction and F arrow direction of Fig. 5. Damage to or inoperability of the packaged integrated circuit 12 due to increased adhesive force and vertical pulling of the cooling system block 13 is mitigated. Furthermore, separately unfixing positioning members from a heatsink or cooling system block and/or a circuit board is unnecessary, making unmounting convenient, less time-consuming, and efficient, and lost parts of and damage to the positioning members less likely.

Therefore, embodiments disclosed herein are well adapted to attain the aims and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A cooling system block assembly (10) adapted for mounting to a packaged integrated circuit (12), comprising:
a cooling system block (13) including a plurality of attachment members (133) and one or more positioning members (132), the plurality of attachment members (133), rotatably disposable through and vertically movable within, the cooling system block (13), the one or more positioning members (132), removably fixable through and vertically movable within, the cooling system block (13); and
a circuit board assembly (6) fixed to the cooling system block (13) via the plurality of attachment members (133), the circuit board assembly (6) including a socket (9) and a plate (7), the socket (9) comprising one or more positioning hubs (90) or one or more positioning pins (99), the plate (7) comprising a plurality of attachment hubs (71), the one or more positioning members (132) rotatably disposable within the one or more positioning hubs (90) or rotatably disposable encompassing the one or more positioning pins (99), the plurality of attachment members (133) removably fixable within the plurality of attachment hubs (71),
wherein when the one or more positioning members (132) is disposed within the one or more positioning hubs (90) or is disposed encompassing the one or more positioning pins (99) and the plurality of attachment members (133) is not fixed within the plurality of attachment hubs (71), the plurality of attachment members (133) is vertically aligned with the plurality of attachment hubs (71).

2. The cooling system block assembly (10) of claim 1, wherein the cooling system block (13) further includes a longitudinal axis and a lateral axis, and wherein when the one or more positioning members (132) is not disposed within the one or more positioning hubs (90) or is not disposed encompassing the one or more positioning pins (99) and the plurality of attachment members (133) is not fixed within the plurality of attachment hubs (71), the cooling system block (13) is movable in a longitudinal axis direction and in a lateral axis direction.

3. The cooling system block assembly (10) of claim 1 or 2, further comprising a fin stack (136) and a plurality of heat pipes (135), the plurality of heat pipes (135) comprising a fin stack portion, a transportation portion, and a cooling system block portion, the transportation portion between the fin stack portion and the cooling system block portion, the fin stack portion coupled to the fin stack (136), and the cooling system block portion coupled to the cooling system block (13).

4. The cooling system block assembly (10) of one of claims 1 to 3, wherein the circuit board assembly (6) further includes a circuit board (8), the circuit board (8) comprising a plurality of board through-holes (85), and wherein the socket (9) further comprises a plurality of socket through-holes (95), the circuit board (8) coupled between the socket (9) and the plate (7), the plurality of attachment hubs (71) protruding through the plurality of board through-holes (85) and the plurality of socket through-holes (95).

5. The cooling system block assembly (10) of claim 4, wherein the packaged integrated circuit (12) is electrically coupled to the circuit board (8) via the socket (9), and wherein the cooling system block (13) is thermally coupled to an upper surface of the packaged integrated circuit (12).

6. The cooling system block assembly (10) of one of claims 1 to 5, wherein the cooling system block (13) further includes a plurality of second counterbores (1312), each plurality of second counterbores (1312) respectively comprises an inner annular ledge (1313), and wherein each plurality of attachment members (133) respectively comprises a compression member (134) and a securing ring (137), the plurality of attachment members (133), rotatably disposable through and vertically movable within, the cooling system block (13) via the plurality of second counterbores (1312), and wherein when the plurality of attachment members (133) is not fixed within the plurality of attachment hubs (71), the securing ring (137) abuts a first side (1314) of the inner annular ledge (1313) and the compression member (134) abuts a second side (1319) of the inner annular ledge (1313), the second side (1319) opposite the first side (1314).

7. The cooling system block assembly (10) of claim 6, wherein the compression member (134) comprises a first compression force and a second compression force, and wherein when the plurality of attachment members (133) is not fixed within the plurality of attachment hubs (71), the compression member (134) comprises the first compression force, and wherein when the plurality of attachment members (133) is fixed within the plurality of attachment hubs (71), the securing ring (137) does not abut the first side (1314) and the compression member (134) comprises the second compression force, the second compression force is greater than the first compression force.

8. The cooling system block assembly (10) of one of claims 1 to 7, wherein the cooling system block (13) further includes one or more first counterbores (1311), each one or more first counterbores (1311) comprises an inner threaded portion (1317), and wherein each one or more positioning members (132) comprises a head (1322), an external threaded portion (1323), and a positioning knob (1321) or a positioning bore (1324), the external threaded portion (1323) is located between the head (1322) and the positioning knob (1321) or the positioning bore (1324), the one or more positioning members (132), removably fixable through and vertically movable within, the cooling system block (13) via the one or more first counterbores (1311) such that the positioning knob (1321) is movable into and out of the one or more positioning hubs (90), or that the one or more positioning pins (99) is relatively movable into and out of the positioning bore (1324).

9. The cooling system block assembly (10) of one of claim 1 to 8, wherein the cooling system block (13) further includes four corners, and wherein the plurality of attachment members (133) comprises four plurality of attachment members (133), the plurality of attachment members (133), rotatably disposable through and vertically movable within, the cooling system block (13), at the four corners of the cooling system block (13).

10. The cooling system block assembly (10) of claim 9, wherein the one or more positioning members (132) further comprises two one or more positioning members (132), the one or more positioning members (132), removably fixable through and vertically movable within, the cooling system block (13), at two opposing sides of the cooling system block (13) and between two opposing plurality of attachment members (133).
